Europäisches Patentamt

European Patent Office

Office européen des brevets

(11) Publication number: **0 182 041**
**A2**

# (12) EUROPEAN PATENT APPLICATION

(21) Application number: **85112092.3**

(22) Date of filing: **24.09.85**

(51) Int. Cl.⁴: **H01L 27/02** , **H03K 19/00**

(30) Priority: **15.11.84 US 671899**

(43) Date of publication of application:
**28.05.86 Bulletin 86/22**

(84) Designated Contracting States:
**DE FR GB IT**

(71) Applicant: **International Business Machines Corporation**
**Old Orchard Road**
**Armonk, N.Y. 10504(US)**

(72) Inventor: **Bechade, Roland Albert**
**12 Green Dolphin Drive**
**South Burlington Vermont 05401(US)**
Inventor: **Concannon, Michael Patrick**
**RD 1, Box 459-4**
**Richmond Vermont, 05477(US)**
Inventor: **Ederlyi, Charles Karoly**
**26 Forest Road**
**Essex Junction Vermont, 05452(US)**
Inventor: **Floyd, Robert Kenneth, Jr.**
**P.O. Box 397**
**Richmond Vermont, 05477(US)**
Inventor: **Seewann, Edelmar**
**11506 April**
**Austin, TX 78753(US)**
Inventor: **Torres, Abraham**
**2403 Rollingwood Drive**
**Austin TX 78746(US)**
Inventor: **Klein, Guenter Werner**
**Skunk Hollow Road**
**Jericho Vermont 05465(US)**
Inventor: **Levy, Jack Robert**
**6, Alderbrook Road**
**Essex Junction Vermont 05452(US)**
Inventor: **McCormick, Peter Edward**
**161 Austin Drive Unit 26**
**Burlington Vermont 05401(US)**
Inventor: **Patel, Mukeshchandra Prabhudas**
**615 Lime Rock Drive**
**Round Rock Texas 78664(US)**

(74) Representative: **Bonneau, Gérard**
**Compagnie IBM France Département de Propriété**
**Industrielle**
**F-06610 La Gaude(FR)**

(54) **Integrated circuit chip with "bit-stacked" functional blocks.**

(57) The integrated chip (10) includes at least one multi-bit data flow path for transferring data from a source functional block to one or more destination blocks, each functional block performing different basic functions such as a register storage function (L15, L16), a switching multiplexor function (L22 or L25) or a compare function and are arranged such that each comprises the same number of stages (n). The register (L15) and multiplexor (L22) blocks are arranged such that each stage within the block is identical, having been formed by a group of basic semiconductor devices which have been interconnected to form a one bit function. The stages are placed physically adjacent and extend in one direction of the chip. The physical width (W) of all such functional blocks is made identical as is the physical width (w) of each stage within a functional block. The functional blocks are placed into "vertical bit stacks" (LS,CS, RS) in which corresponding stages of different blocks are in vertical alignment. Interconnections between blocks are made through a predetermined

0 182 041

number of location pre-allocated global buses, (40, 50) said predetermined number reflecting both the number of functional blocks within a stack as well as their average interconnectivity.

FIG. 1A

## INTEGRATED CIRCUIT CHIP WITH "BIT-STACKED" FUNCTIONAL BLOCKS

This invention relates in general to large scale integrated circuit chips and in particular, to an integrated circuit chip in which multi-stage functional blocks are aligned or "stacked" vertically on the chip so that the corresponding stages of each block are in a vertical alignment to permit interconnection by global wiring.

The prior art has disclosed various arrangements for implementing on an integrated circuit chip, circuits that process binary data. While the arrangements all have the same general objective of providing low cost function on each chip, the manner in which the devices are interconnected to form circuits and these circuits are then interconnected to form higher level functional blocks varies as different priorities are placed on the various factors that influence this cost. For example, the layout, meaning the position of the semiconductor devices and their interconnections, for two chips each implementing the same complex logical control function and each employing the same basic semiconductor technology can differ substantially if the first places a high degree of emphasis on reducing development cost and the second places a high degree of emphasis on reducing volume manufacturing cost. One of the main reasons for this difference is the set of constraints imposed by such emphasis on the method of providing for the global wiring pattern which interconnects circuits and blocks.

In some integrated circuit arrangements of complex logical control functions, automatic procedures are employed to produce the layout of the circuits and the wiring. Since both the layout and the wiring must follow prescribed rules in this approach, compromises are made between the wirability of the chip and the number of circuit devices per chip and, quite often, less than optimum integration is achieved.

In other integrated circuit arrangements, the chips start out with a basic organization of devices and are later personalized by wiring in the last stages of the process to implement a specific logical function or system. While this makes the overall process economical from a development cost per chip standpoint, it frequently results in the need to employ a number of chips to implement a function that, with proper planning from the beginning, could have been implemented on a single chip. Hence, the apparent economic saving is lost and overall system performance is degraded by the additional buffering needed to boost signal levels through these unwanted chip to chip connections. It is therefore highly desirable in performance and/or manufacturing cost oriented designs to provide as much function on one chip as possible.

A chip layout of circuits done on a custom basis can, in theory, result in the most densely packed layout of circuits and wiring. However, this is no longer practical at the present level of large-scale integration because of the extremely large number of circuits involved unless the chip is partitioned into functional blocks. Moreover, for this latter approach to be schedule and development cost competitive, it is very desirable that many of these functional blocks belong to a family of predesigned units which can be used on more than one chip.

It is therefore an object of the present invention to provide an integrated circuit chip that is highly integrated and avoids costly and performance degrading chip to chip connections.

A second object of the present invention is to provide an improved layout for an integrated circuit chip which is implementing a system that comprises a relatively high proportion of interconnected multistage blocks having different functions.

Another object of the present invention is to embody a data handling system, having at least one multi-bit data flow path involving a plurality of functional blocks on a semiconductor chip in an arrangement which permits a high utilization of the chip area.

A further object of the present invention is to accomplish the physical design in a schedule and resource efficient manner by using members of a family of predesigned functional blocks during the design process.

It has been found in accordance with the present invention that when the application to be embodied on the chip involves a high proportion of multi-stage functional blocks, such as is normally encountered in certain portions of a data processing system where multi-bit data words are transferred between different parts of the system, an approach referred to as "bit stacking" produces a highly efficient layout of circuits and metalization.

In accordance with the "bit stacking" concept, the multi-stage functional blocks all have the same number of stages, with each stage handling or processing one bit of a multi-bit word. Generally in the application under consideration, one or more multi-bit data paths exist in the design for transferring a multi bit word, for example 32 bits, between a source functional block through a number of other blocks, perhaps having other functions, to a destination functional block. The present invention teaches that, in this type application, each stage of the functional blocks be designed to have the same physical width even though corresponding stages of blocks having different functions might employ a different number of basic semiconductor devices. Since each individual stage has basically one width, 'w', and a large majority of the blocks have the same number of stages, all blocks have the same width, 'W'. If the blocks are stacked vertically on the chip such that corresponding logical stages are aligned and if the order of the blocks reflects, whenever possible, the sequence of the data flow, the implementation of the global wiring in two levels of metalization, as well as the implemention of whatever metal wiring is required for interconnecting devices within a stage and that required in interconnecting these stages within a functional block, is tremendously simplified. This permits a closer packing density of the functional blocks and hence, an integrated circuit package with a relatively high degree of function.

Objects and advantages other than those mentioned above will become apparent in the following description when read in connection with the drawing.

Figs. 1a - 1f when assembled as shown in Fig. 1g are a plan view of an integrated circuit chip embodying the present invention.

Fig. 1g shows how Figs. 1a - 1f are related.

Fig. 2 comprising Figs. 2a - 2i is a block diagram of an address translator that is implemented on the chip shown in Fig. 1.

Fig. 2j shows how Figs. 2a - 2i are related.

Fig. 3 comprising Fig. 3a and Fig. 3b is a block diagram of the storage interface function that is also implemented on the chip shown in Fig. 1.

Fig. 4 is a schematic illustration of a latch circuit employed to store one bit in one stage of a register block shown in Fig. 1.

Fig. 5 is an equivalent logical diagram of the latch circuit shown in Fig. 4.

Fig. 6 is a top plan view of a modular portion of the chip shown in Fig. 1 illustrating diagrammatically the elements in each layer of the chip in a superimposed relationship.

Figs. 7a - 7h illustrate the structures that are implemented in each of the 7 layers shown superimposed in Fig. 6.

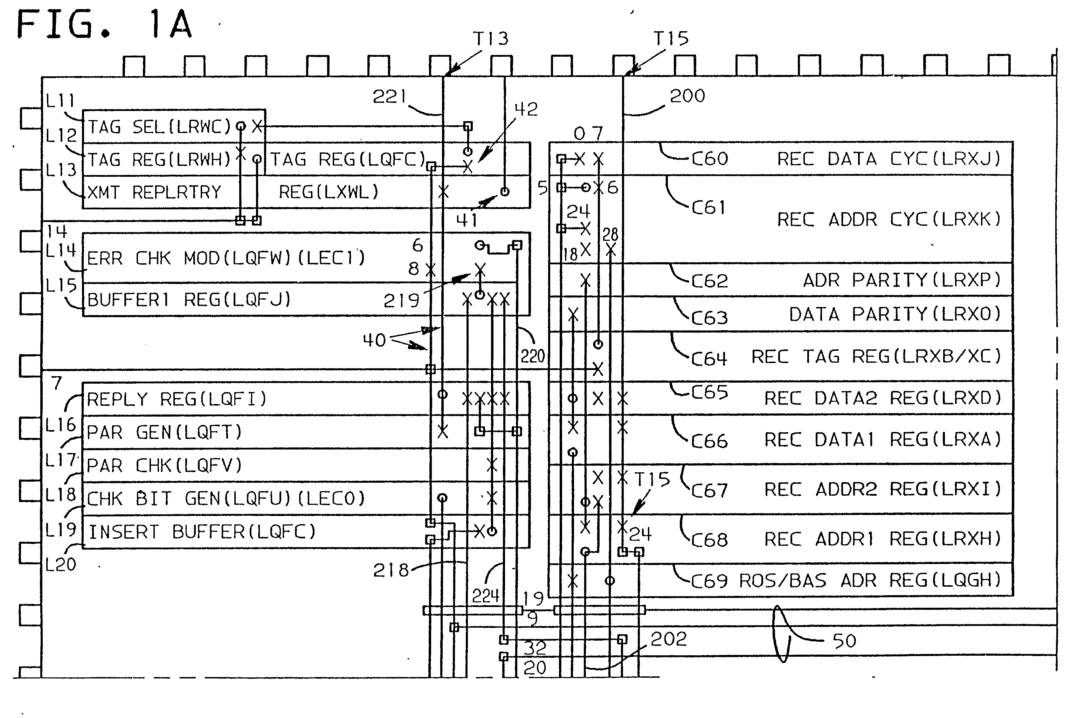

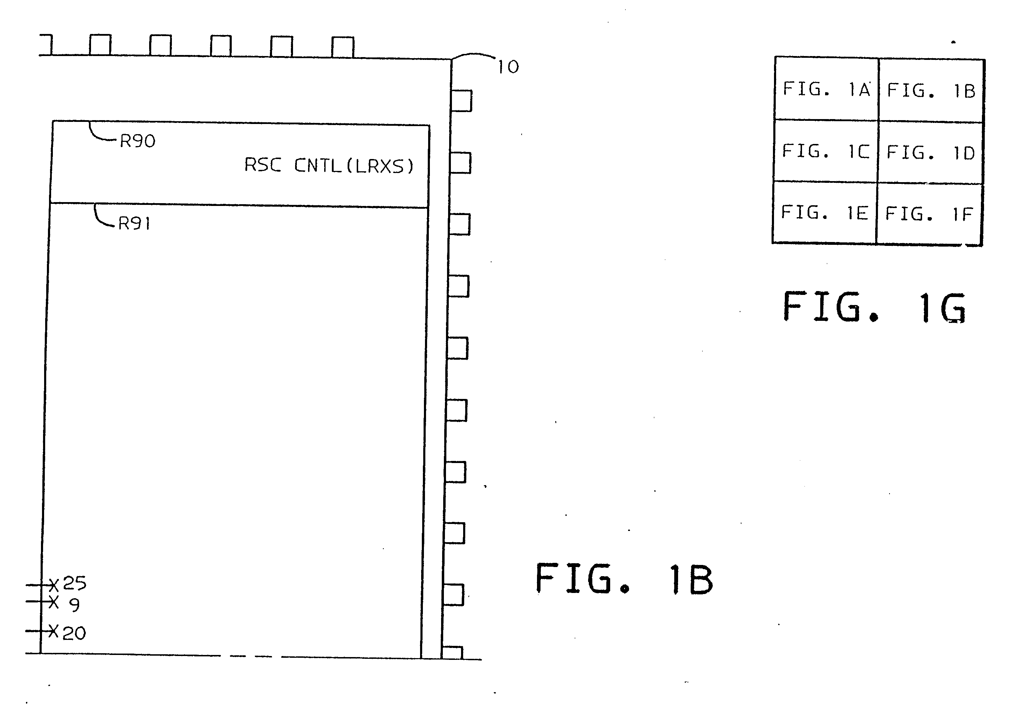

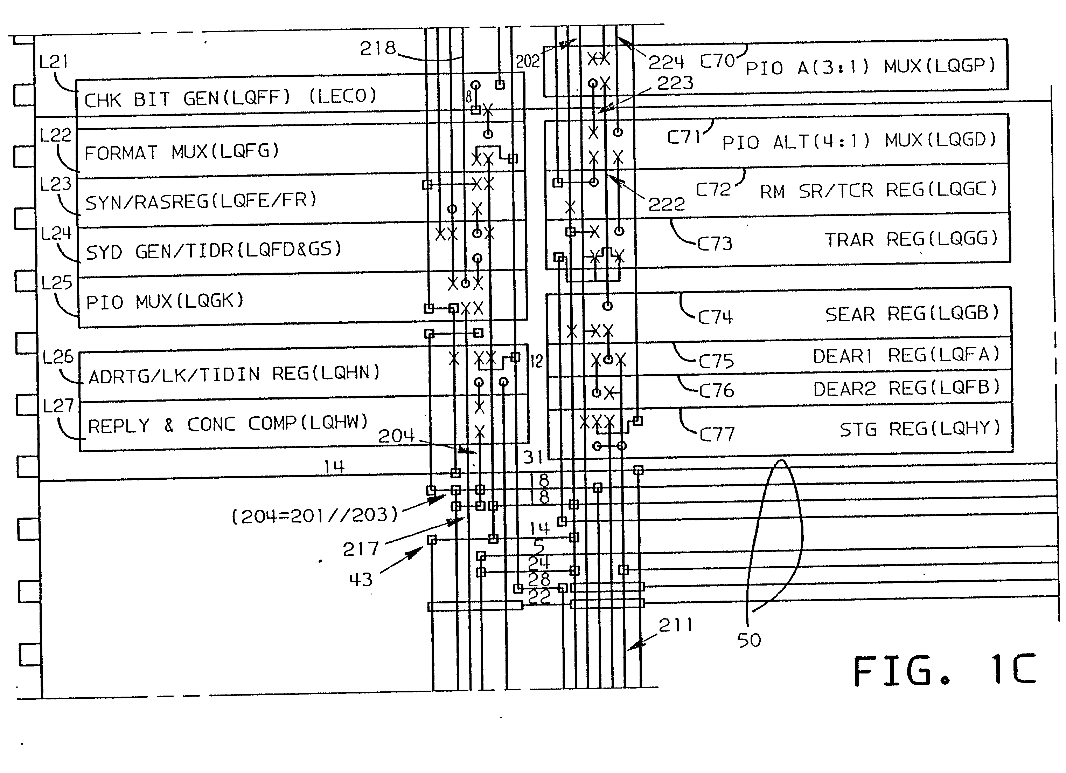

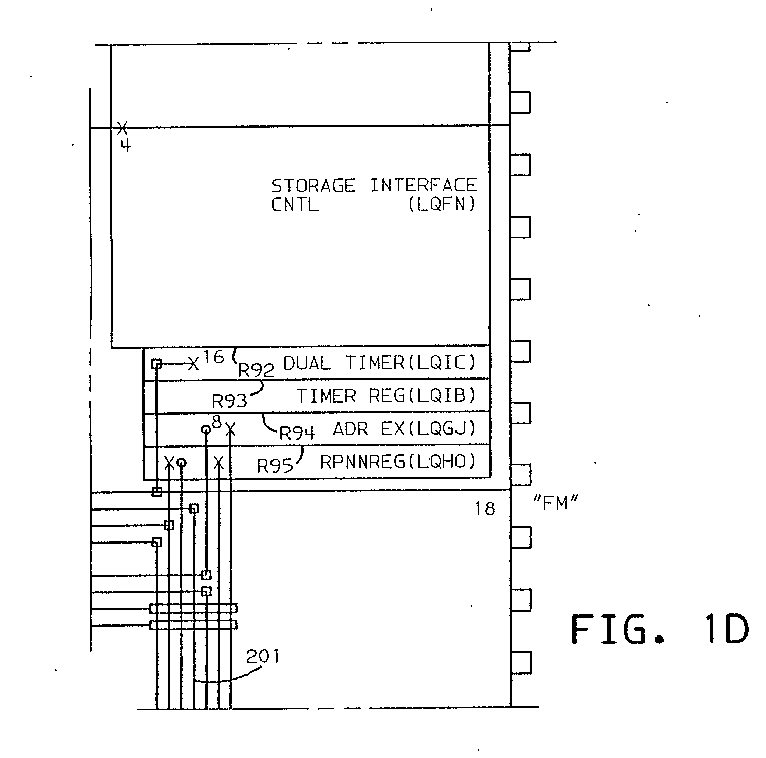

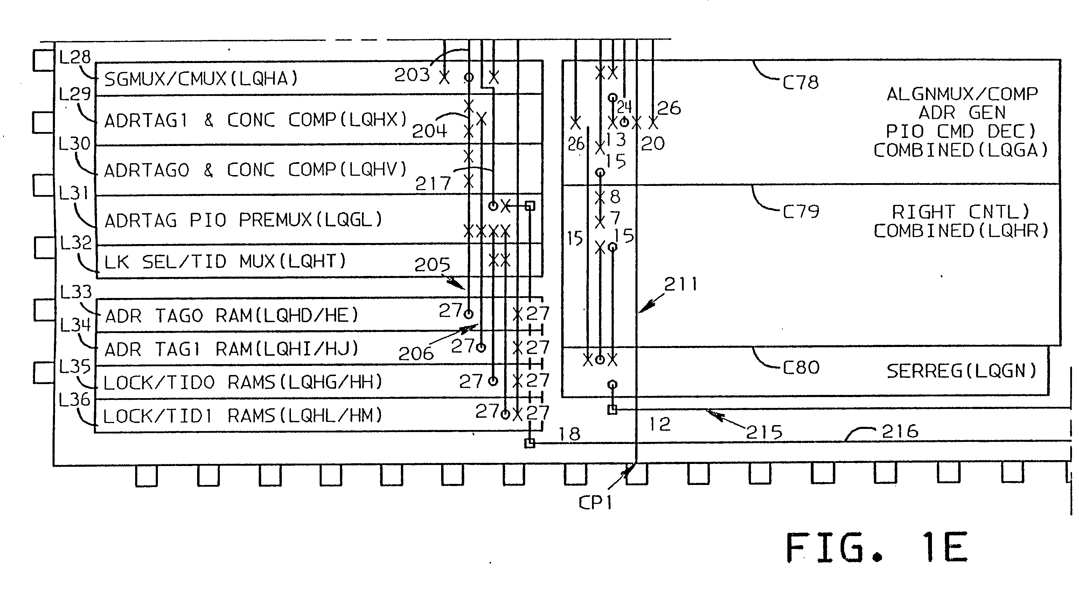

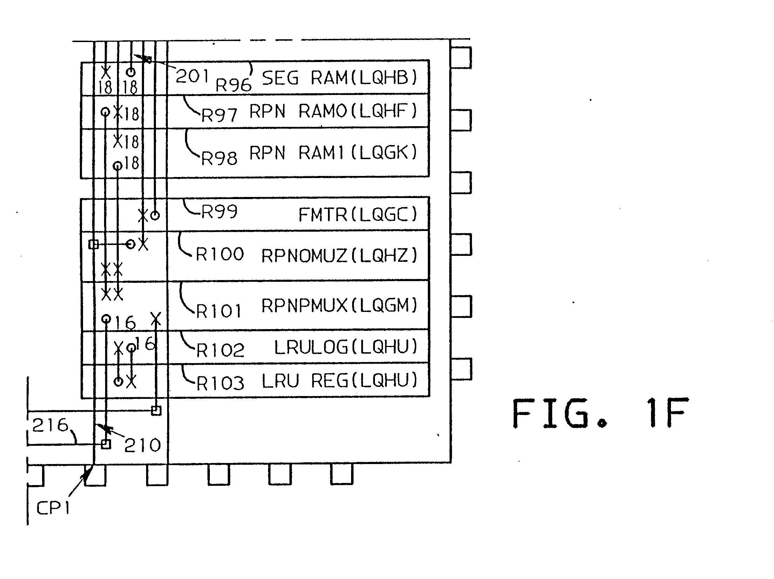

Figs. 1a - 1f taken together as shown in Fig. 1g and referred to hereafter as Fig. 1 illustrate diagrammatically an integrated circuit chip 10 which embodies the present invention. An important characteristic of the present invention is seen from the plan view of chip 10 in Fig. 1. Chip 10 has a general organization which comprises three columns or stacks, the left stack (LS), the center (CS), and the right stack (RS), each of which comprise a group of functional blocks. The left stack (LS) comprises the following functional blocks which are listed from the top horizontal side 11 of chip 10 in the order in which they appear in the stack.

PSC Output Tag Select Logic L11

PSC Output Tag Register L12

Transmit Reply Register L13

Error Checking Module L14

PSC Output Buffer 1 Register L15

PSC Reply Register L16

Parity Generator L17

Parity Checker L18

Check Bit Generator L19

Insert Buffer L20

Check Bit Generator L21

Format Multiplexor L22

Syndrome Register and RAS Mode Diagnostic Register L23

Syndrome Generator and Transaction Identifier Register L24

Programmed Input/Output Multiplexor L25

Address Tag Register, Lock and Transaction Identifier

Input Register L26

Reply vs Concatenated Comparator L27

Segment Multiplexor L28

Address Tag 1 vs. Concatenated Virtual Address

Comparator L29

Address Tag 0 vs. Concatenated Virtual Address

Comparator L30

Address Tag PIO Premultiplexor L31

Lock Select/Transaction Identifier Multiplexor L32

Address Tag 0 RAM L33

Address Tag 1 RAM L34

Lock 0/Transaction Identifier 0 RAM L35

Lock 1/Transaction Identifier 1 RAM L36

The functional blocks in the center stack (CS) in the order in which they appear from the top edge 11 downward are as follows:

PSC Received Data Logic C60

PSC Received Address Logic C61

PSC Address Parity C62

PSC Data Parity C63

PSC Received Tag Register C64

PSC Received Data 2 Register C65

PSC Received Data 1 Register C66

PSC Received Address 2 Register C67

PSC Received Address 1 Register C68

ROS Specification and I/O Base Address Registers C69

PIO Multiplexor C70

PIO Alternate Multiplexor C71

RAM Specification Register and Translation Control Register C72

Translated Real Address Register (TRAR) C73

Storage Exception Address Register (SEAR) C74

Delay I Exception Address Register (Dear I) C75

Delay 2 Exception Address Register (DEAR 2) C76

Storage Register (STG) C77

Address Generator C78

Right Control C79

Storage Exception Register (SER) C80

The right hand stack (RS) comprises the following functional blocks:

PSC Control R90

Storage Interface Control Logic R91

Dual Timer R92

Timer Register R93

Address Extension Register and Logic R94

Real Page Number Register (RPN) R95

Segment RAM R96

Real Page Number (RPN) RAM 0 R97

Real Page Number (RPN) RAM 1 R98

Formator R99

Real Page Number Output Multiplexor R100

Real Page Number PIO Multiplexor R101

Least Recently Used (LRU) Logic R102

Least Recently Used (LRU) Register R103

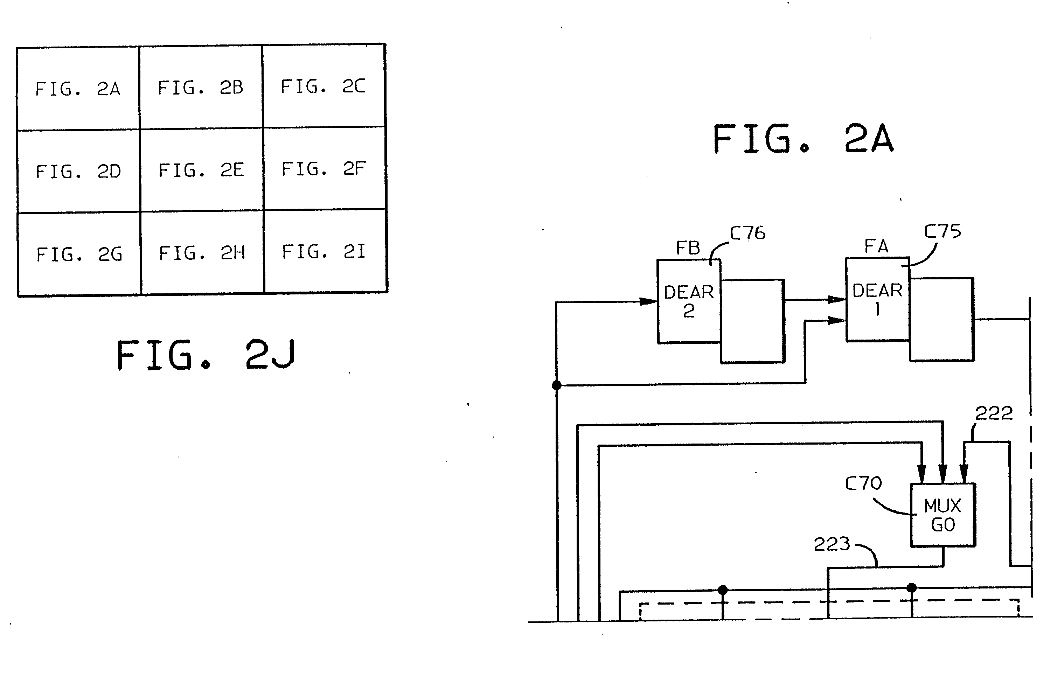

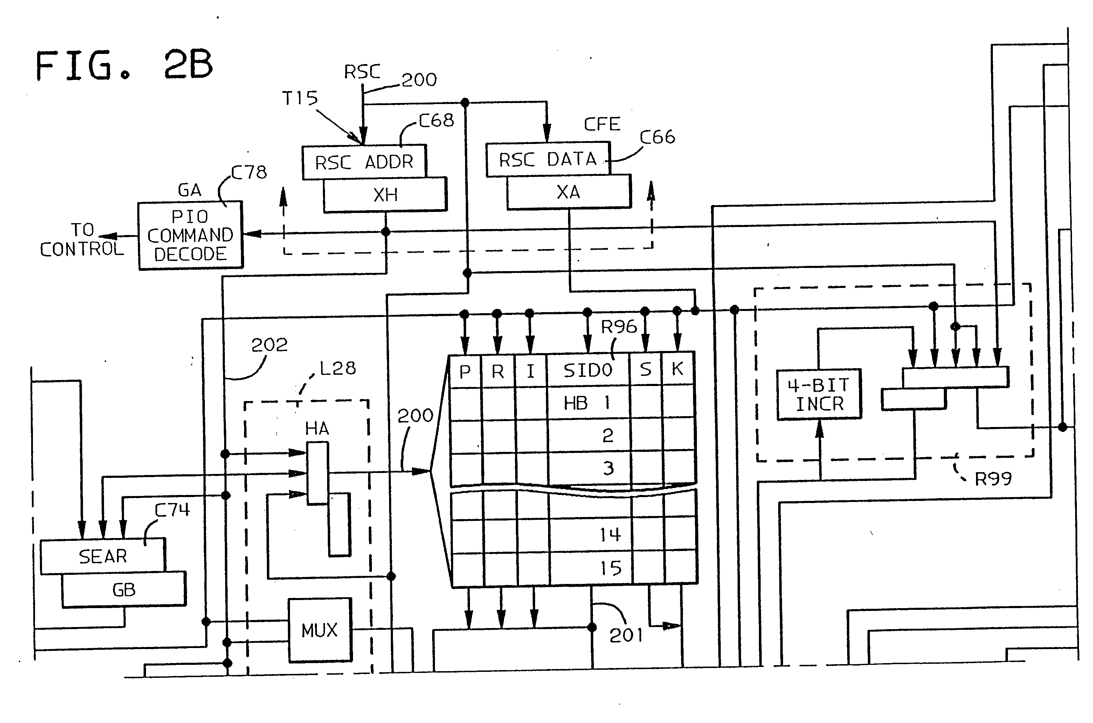

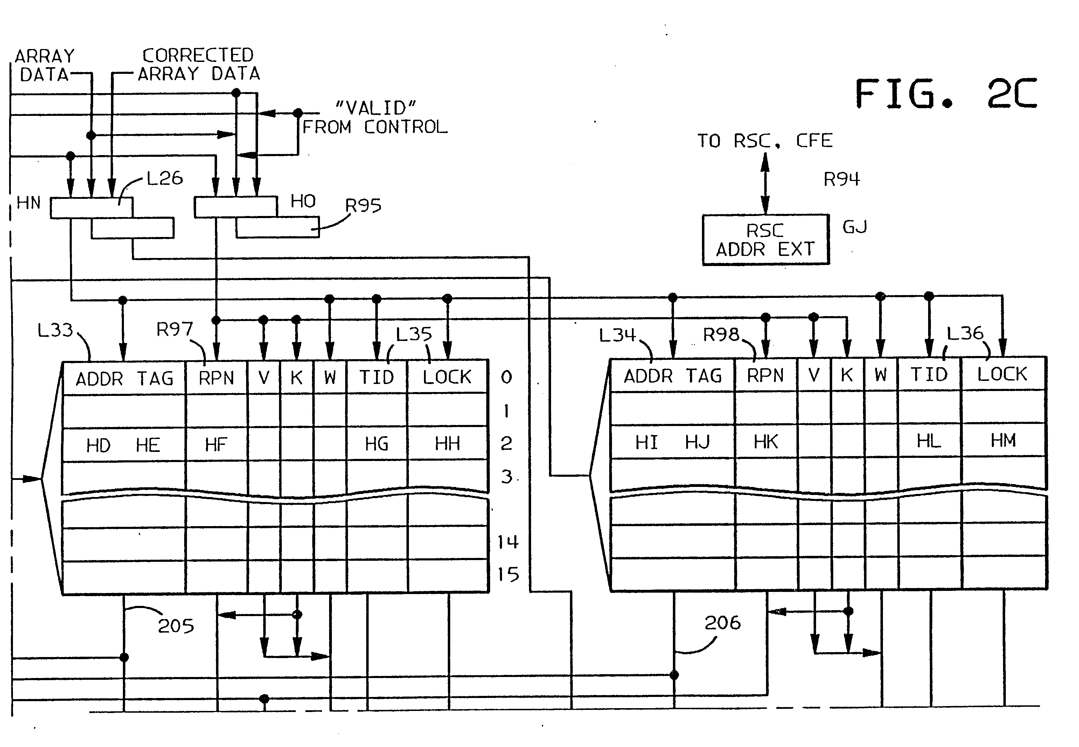

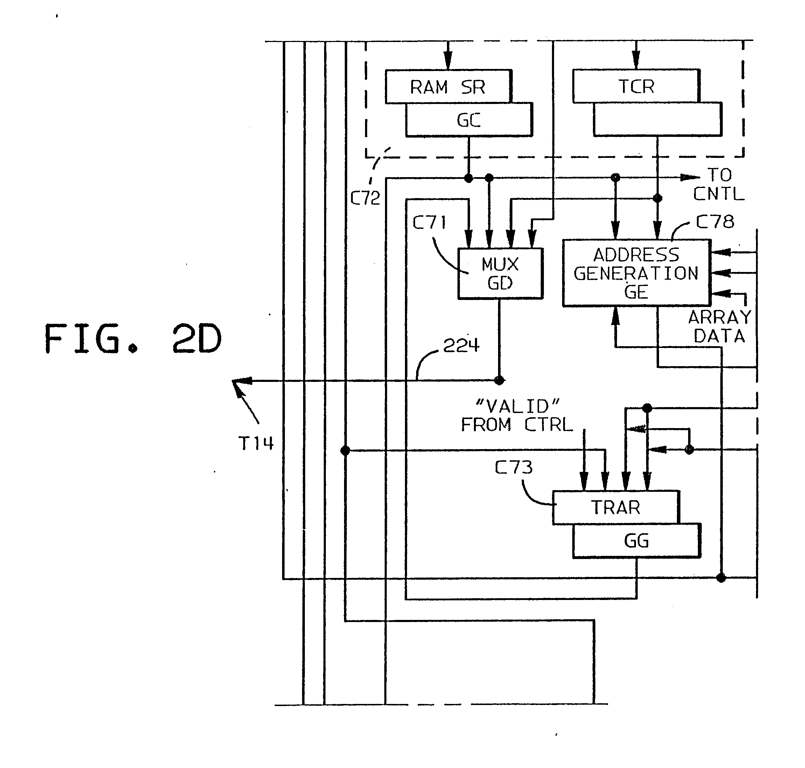

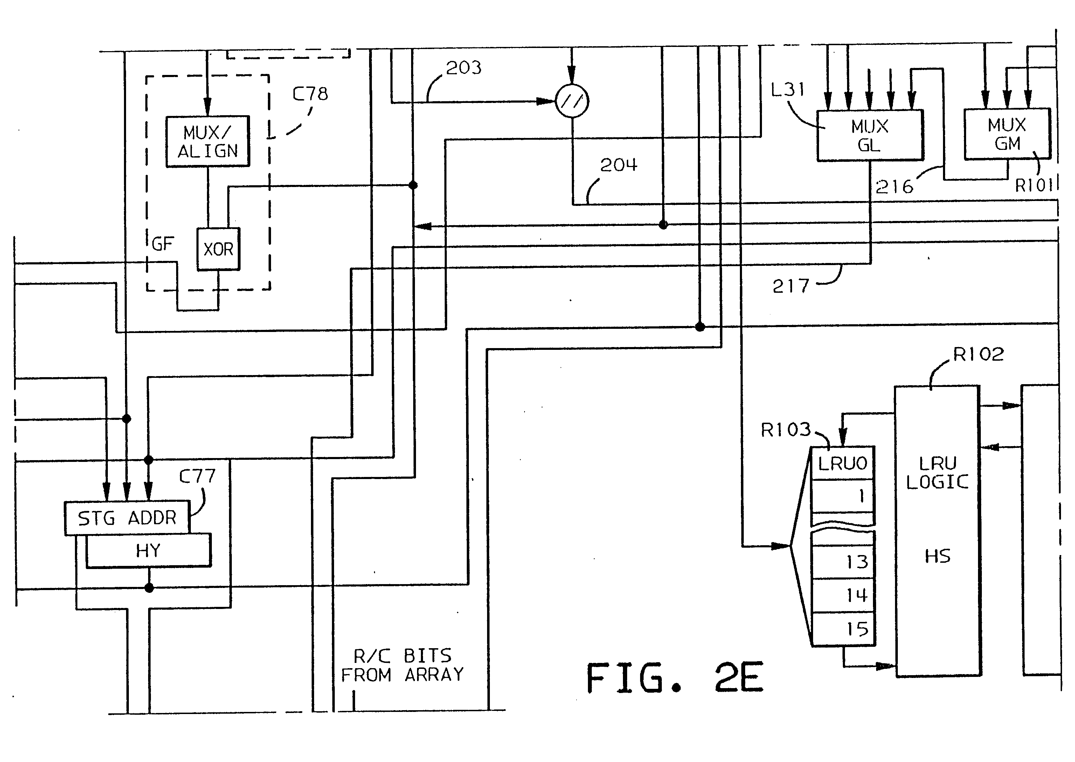

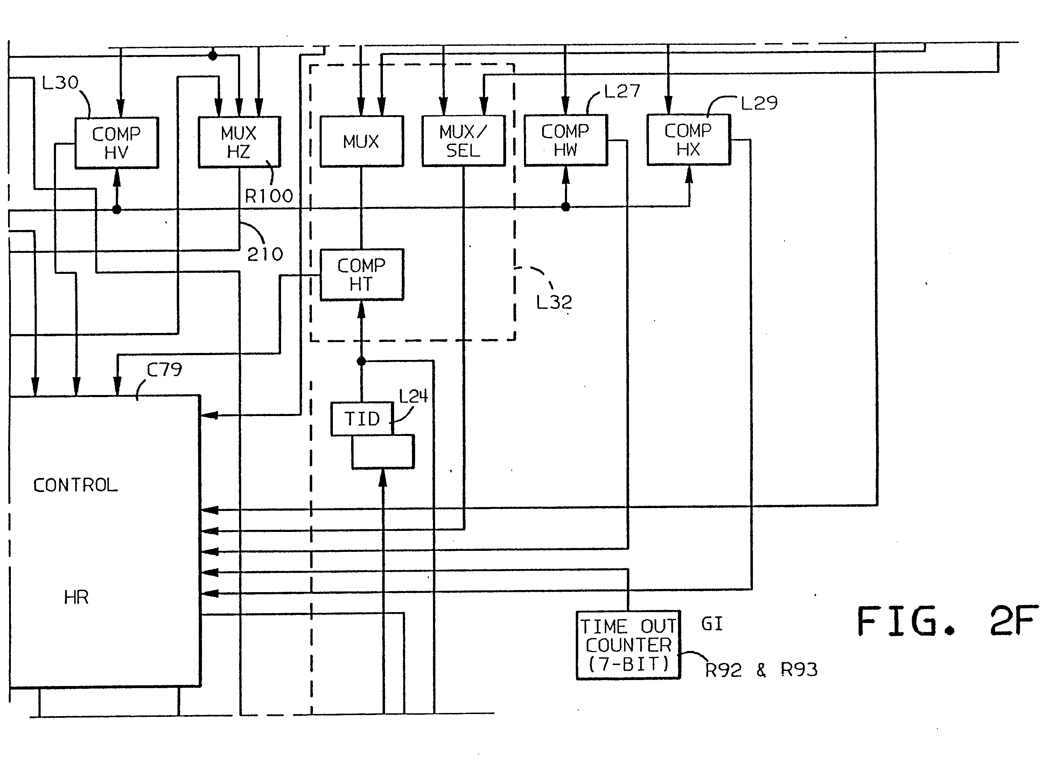

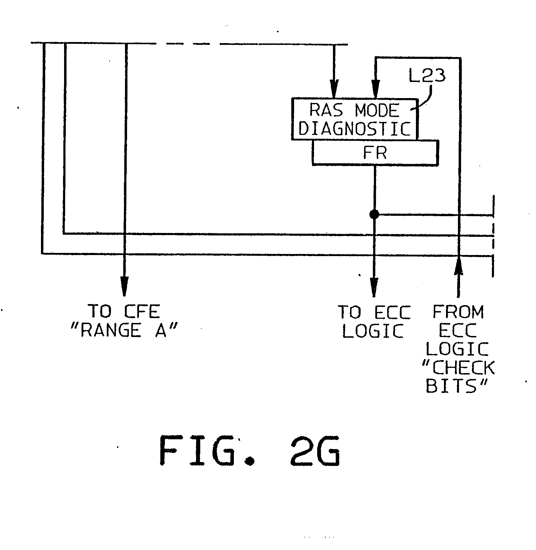

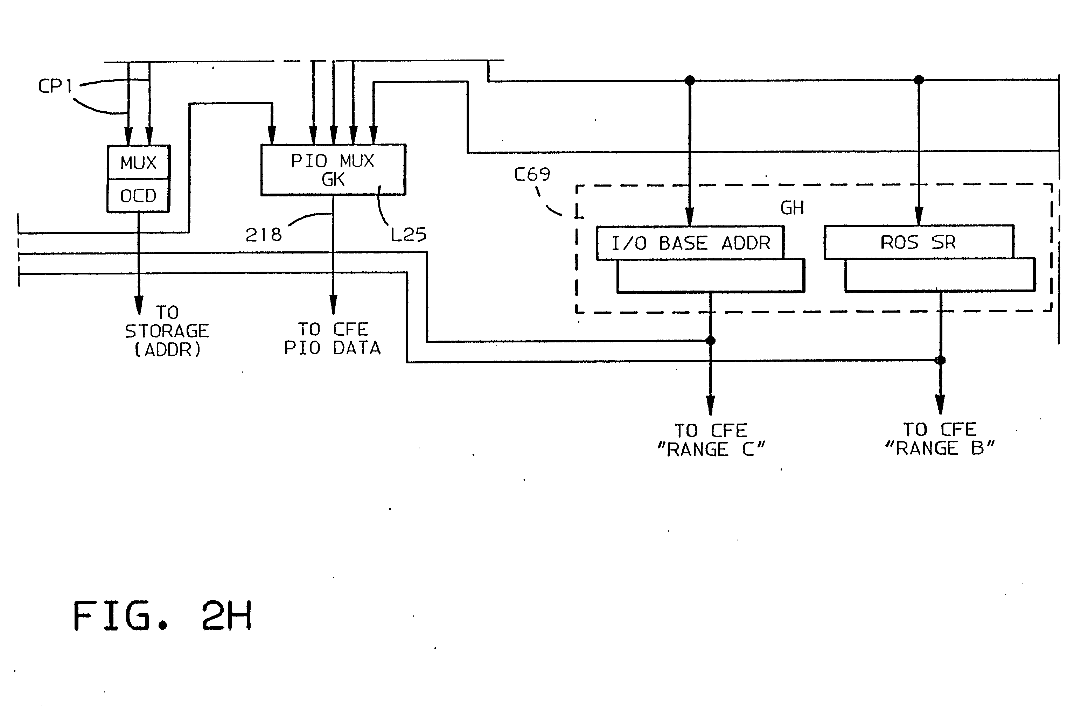

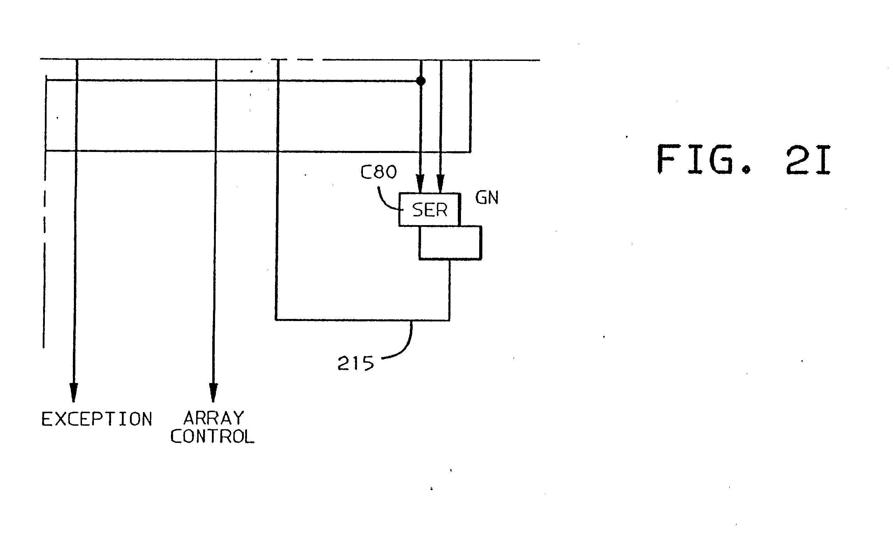

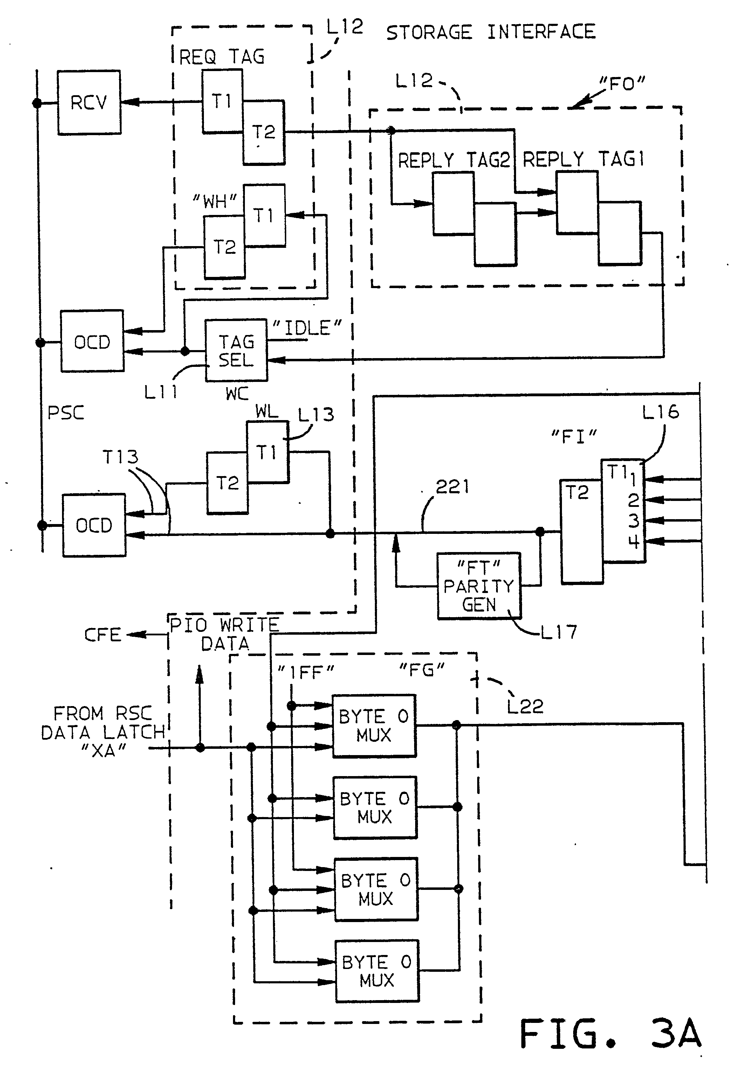

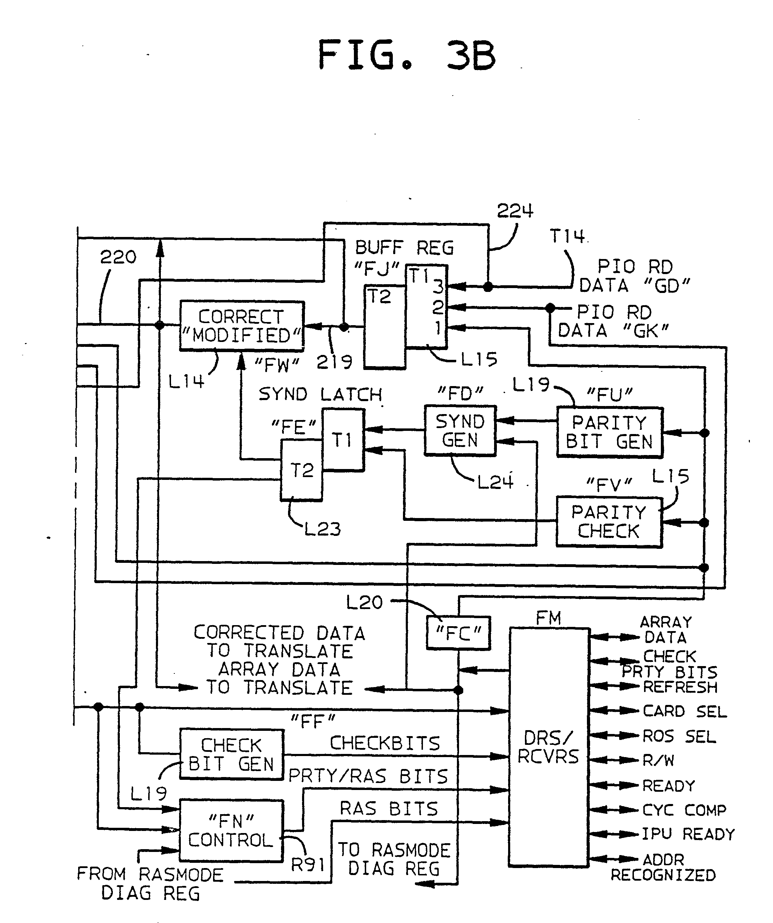

The blocks L12-L36 in the left stack (LS) as shown are all of the same physical width "W" except for block L11 which consists of a block having a width of W/2. Each block has the same number "n" of stages "s" except L11 which has (n/2). Each stage of each block also has the same width, "w", and corresponding stages of the blocks in each stack are aligned physically on the chip. The number of stages in each block corresponds to the overall composite word width of the data flow paths that have been established on the chip to implement a predetermined function of a data processing system. In this instance, the function implemented on the chip is referred to as "address translation" which involves converting a "virtual" memory address to a "real" memory address. The logical arrangement of the blocks shown in Fig. 1 is illustrated in Fig. 2 and Fig. 3 in a conventional system block diagram, and is discussed later on in the specification in connection with a specific data flow path.

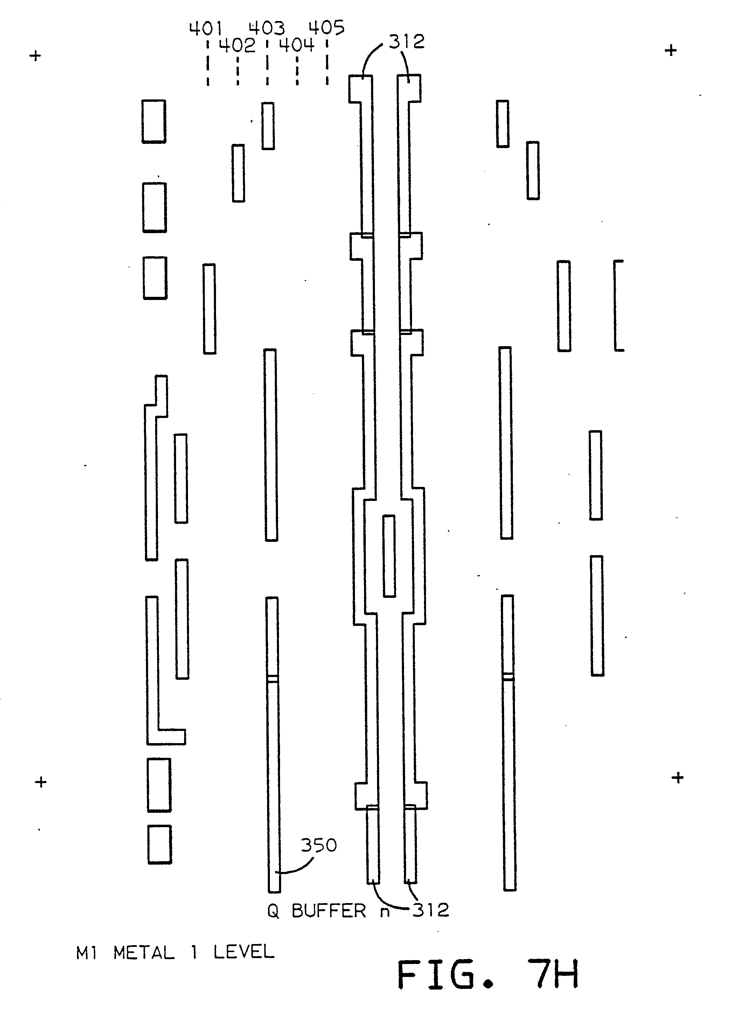

At this point, it is important to understand that the system function that is implemented on the chip 10 is only significant to the invention in that it demonstrates a number of different data flow paths involving a number of functional blocks which perform different processing functions. For example, the left stack LS contains register blocks, multiplexor blocks, check bit generators, parity generators and parity check generators, etc. While the blocks vary in function, they all have the same physical width, "W", determined by the physical width, "w", of the stages and the overall composite word width, "n", of the data flow path. It should be understood that although the physical width "w" is kept constant throughout the stack, that n/2 or n/4 "logical bit width" words are supported by this bit stacking concept provided 2(n/2) or 4(n/4) stage functional blocks are placed adjacent to one another to form an n-bit physical word. Various blocks in the left stack are interconnected by buses 40 which, as shown, are vertical lines starting at an output terminal on one block, represented by a small circle or 0 designated by reference character 41 and ending at one or more input terminals of other blocks represented by an X and designated 42. Each bus 40 represents "n" conductors where n is the number of data bits in the data flow path. These buses in practice are formed in the metal one layer of the chip shown in Fig.7h and are organized as 4 separate groups of 7 buses each, as explained later in the specification.

The center stack (CS) and right stack (RS) are arranged in a manner similar to the left stack. The various functional blocks in the (CS) and (RS) stack are appropriately labeled with the legends indicating their general function, together with appropriate reference characters which are also employed in the more conventional data flow diagram of Fig. 2 and Fig. 3. The blocks in the center stack CS and right stack RS are appropriately interconnected by buses 40 as described in connection with the left stack.

A second set of buses 50 shown in Fig I is disposed 90 degrees to the vertical buses 40 and functions to interconnect selected blocks in the different stacks by interconnecting different pairs of vertical buses 40 associated with the same stack. The latter interconnection is represented by a square block 43 where the two buses cross. Connections 41, 42, and 43 represent conventional interlayer connections between either the two layers of metalization M1 and M2 in the chip or one layer of metalization and a terminal contact formed on the layer of the actual semiconductor device.

The chip 10 is also provided with external connecting pads around its periphery for providing external input and output connections to the chip. It can be seen that a relatively large proportion of chip area is allocated to multistage functional blocks.

The overall function of the address translation system as shown in Fig. 2 and Fig. 3 involves a conversion of one binary number representing a virtual address in some relatively large storage subsystem to another binary number representing a real physical address in that storage subsystem. The chip is basically a storage controller that interconnects the processor storage channel on one side to the main storage on the other side and implements the following three general functions:

1. The Processor Standard Channel (PSC) interface. This logic implements the proper communication protocol from the PSC to the address translation logic and storage controller logic on the chip 10. All communication to and from the PSC is handled by this logic. This logic although fully represented in Fig. I is not supported by an accompanying conventional system block diagram as are the other two general functions.

2. The second major function is the address translation function shown in Fig. 2. This logic implements the translation from a 32 bit virtual or "effective" address received from the PSC to a real or physical address used to access storage. The low order 12 bits (bits 20-31) of the incoming effective address are used as the byte address within a "real page" (the 12 bit address of which is to be determined by the address translation mechanism), and are not altered by the translation process, but are instead directly output to storage from the storage address register C77. The high order 4 bits (bits 0-3) of the incoming effective address are used to index into a "segment table" (16 x 18 RAM R96) to select 1 of 16 18 bit registers, the contents of which are intermittently updated by an operating system control program. Twelve of the 18 bits of the referenced segment register contain a segment identifier which is concatenated with 12 bits (bits 4-15) of the incoming effective address to form a 24 bit "virtual" address. Bits 16 - 19 of the incoming effective address are used to address two table look-aside buffers (TLBs) in parallel.

(The contents of the TLBs are intermittently updated by the controller from a "page table" area maintained in main storage by an operating system program.) The address tag field (24 bits) of each table look-aside buffer is compared to the 24 bit virtual address which has been formed as described above. If either of the two compares are equal, then the real page number field of the associated table look-aside buffer contains the remaining 12 bits of the real address (the real page) and is subsequently output to storage as the real page address. These 12 bits, in conjunction with the 12 bits output previously, form the entire real address used to access main storage.

3. The third and last function of the storage control is to provide the address, data, and storage control signals from the controller to the external storage. Error detection/correction (ECC) logic, as well as dynamic memory refresh control is also provided by this function. This function is shown in Fig. 3.

The main input on the chip 10 for receiving an address from the microprocessor which is to be translated, is at terminal T15 of the input register C68. Register C68 appears at the top of Fig. 2b and is in the center stack of Fig. 1. Register C68 is a 32 data bit register (four additional bits are used for parity). The four high order bits of the 32 data bits stored in register C68 are applied to the addressing circuit of the segment RAM R96 by bus 200, a 4 bit output of multiplexor L28. The 12 bit output bus 201 of the RAM R96 is concatenated with the middle 12-13 bits of the original address stored in register C68, to form bus 204. (The 32 bit output of register C68 on bus 202 is divided and 12 bits of the concatenated virtual address are supplied through the multiplexor L28 on bus 203.) The result, comprising 24 bits, is supplied to the comparators L29 and L30 on bus 204, which is the search argument for the address tag RAMs L33 and L34, each of which supplies a 24 bit comparison word on buses 205 and 206 to the other input of the comparators L29 and L30 respectively.

If a match is found, the translated address high order bits are obtained from the associated real page number RAM R97 or RAM R98 through multiplexor R100 and are output through bus 210 to a combination off chip driver/multiplexor located chip periphery (CP1). The low order 12 bits of the "real" address are routed to this same peripheral multiplexor through bus 211 from the storage register C77 and have not been translated since they were directly supplied on bus 200 to storage register C77 from terminal T15.

It should be understood that the above description of the translation function is merely to provide a background for an understanding of the relationship of the blocks shown in Fig. 1 to those shown in Figs. 2 and 3 and to demonstrate how these blocks are logically and physically interrelated. The buses involved in the above description have been identified in Figs. 1, 2 and 3 with corresponding reference characters.

The various data flow paths that are established in the chip 10 and the logical organization of the various functional blocks is more readily understood from Figs. 2 and 3 and the following description of a typical operation that involves transfer of an "n" bit word from a source block to a destination block through a number of other functional blocks. It should be understood that the term "data flow path" describes the path that an n bit data word traces when the word is transferred parallel by bit between a pair of blocks, each of which is capable of storing the word, at least temporarily. A segment of the data path, on the other hand, involves a portion of the data flow path involving at least one block at the start or end of the segment where the data word is not stored, such as in a multiplexor.

The overall function of the arrangement shown in Fig. 1, as mentioned previously, is address translation. In order to better relate a data flow path in Figs. 2 and 3 to the corresponding paths in Fig. 1, a description of a Programmed Input/Output (PIO) read function will now be described. The data flow paths and segments involved in that operation will be traced on both Fig. 1, Fig. 2 and Fig. 3.

A PIO function occurs when something has gone wrong in the general system in the address translation function. When this occurs a supervisory program is called by the system's microprocessor and this program takes control to determine what went wrong. The first step taken by the program is to issue a PIO read command which causes the contents of the Storage Exception Register (SER) C80 to be transferred off the chip as PIO data at terminal T13, by routing it through multiplexors R101, L31, L25, register L15, function block L14 and register L16. The data flow path discussed above from the SER register C80 to the PIO multiplexor is indicated by bus 215, that from R101 to L31 by bus 216, that from L31 to L25 by bus 217, that from L25 to register L15 by bus 218, that from L15 to L14 by bus 219, that from L14 to register L16 by bus 220 and finally that from register L16 to terminal T13 by bus 221. It must be understood that the PIO function is not performance critical. Assuming that the contents of the output word are analyzed by the microprocessor and that this analysis indicates that a page fault has occurred, that is, the data is not in memory but is still on the disk, the processor then issues another PIO command. This command reads the contents of the Storage Exception Address Register (SEAR) C74 (Fig. 2b) to find out at what address the error occurred. The system then takes corrective action by loading the proper page from disk memory into main storage and returns the processor to the original program.

The data flow path from the SEAR register C74 through multiplexor C70 to multiplexor C71 to register L16 and finally to terminal T13 is a typical multisegment data flow path which the present invention implements in a very efficient manner. The segments of this path have been highlighted in Fig. 2 and Fig. 1 and each segment is identified on both figures with the same reference character. The segment 222 extends between register C74 and multiplexor C70. Segment 223 extends from multiplexor C70 to multiplexor C71. Segment 224 connects the output of multiplexor C71 to the input of L16. The segment which extends from the output of register L16 to terminal T13 is labeled 221. Terminal T14 on Fig. 2 connects to terminal T14 on Fig. 3, which in turn is connected to the inputs of the buffer register L15 and to the input of the reply register L16.

The output of buffer register L15 is connected to the input of Error Check block L14 by bus 219. Bus 220 connects the output of L14 to another input of the reply register L16. The output of the reply register L16 is connected to an Off Chip Driver/Multiplexor Circuit (OCD) 110 by bus 221 at terminal T13. This latter path is selected if register L16 already contains PI0 data that has not yet been output to the system microprocessor. The multisegment data path described above is one of many typical data paths that are established in the systems shown in Fig. 1 and Fig. 2 and 3 which are readily implemented by the present invention.

The details of a typical stage of a register type functional block involved in this multisegment data path and its interconnections will now be described.

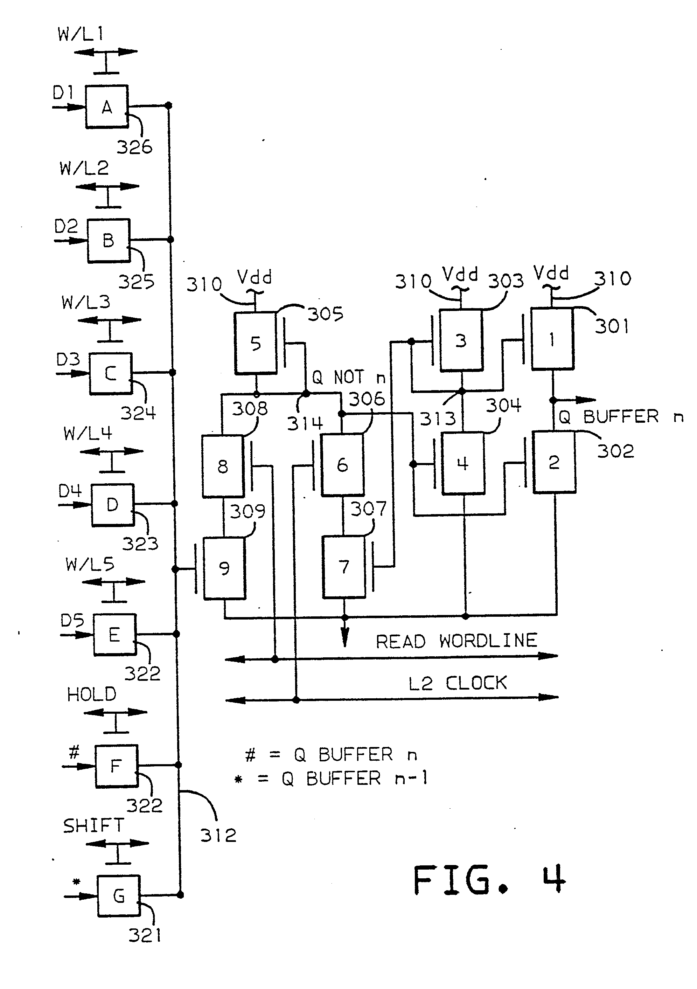

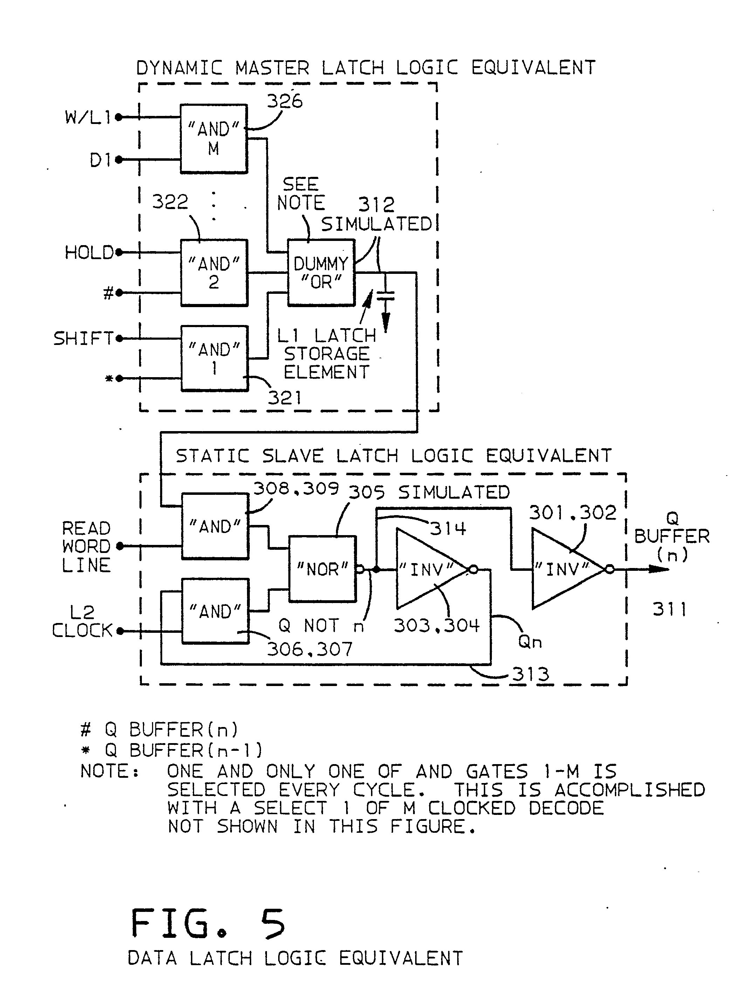

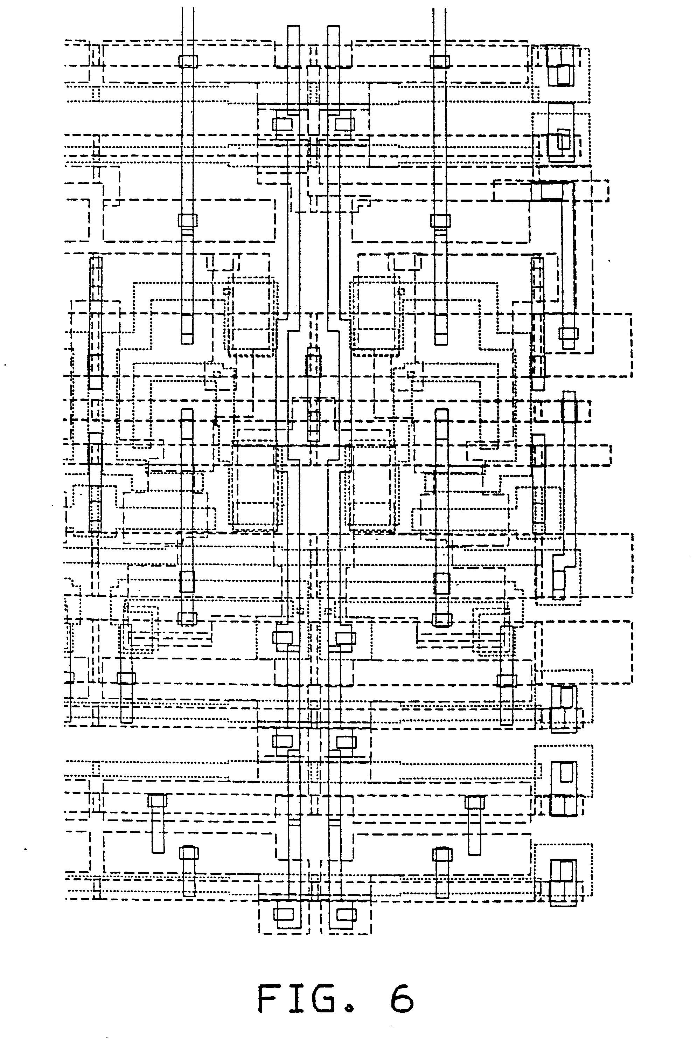

Each of the register blocks in Fig. 1 comprise, for example, 32 stages where each stage comprises one latch circuit of the type shown schematically in Fig. 4 and logically in Fig. 5. The slave latch of this master-slave pair, as shown, comprises 9 individual semiconductor devices 301-309 which are FET type transistors. Devices 305 and 303, which each have one side connected to the voltage terminal 310, are as indicated by the "/" between the gate electrode and the main body, depletion load devices. A single output terminal 311 is provided at the "Q buffer n" output terminal. Terminal 313 between devices 303 and 304 provides a "+Qn" internal signal and terminal 314 provides a "Q not n" internal signal. Input terminal 312 is supplied with at least three mutliplexed input signals through gate devices 321-326. Gate device 321 is provided for entering shift data to the latch during LSSD testing. Signals supplied by gate 322 are from the output terminal 311 of the current stage. This insures and defines a polarity hold latch. The third input for terminal 312 is one of the data in-lines. Gate devices 321-326 together with the input gate capacitance of device 309 comprise a master latch in which the capacitance of terminal 312 acts as the storage element. Only one data in-line is selected at a time. The number of data input lines provided depends on the particular register and is determined by the number of FET devices that are associated with each stage. The devices are also labeled in the layered drawing of the stages in Fig. 6 and will be discussed in more detail later on in connection with that figure.

The FET devices shown schematically in Fig. 4 are shown in logic equivalent form in Fig. 5 using AND, OR and Invert circuits. Devices 301 and 302 shown in Fig. 4 function to isolate the output circuit of the latch so as not to affect its basic performance. The circuits of Fig. 5 have been identified with the same reference characters employed in Fig. 4 so that the devices can be related in both drawings.

It should be understood that the latch circuit shown in Figs. 4 and 5 is merely one example of a latch circuit which may be employed as a stage of a register. Other latch circuits known in the art may also be employed, depending on considerations that are not relative to the present invention.

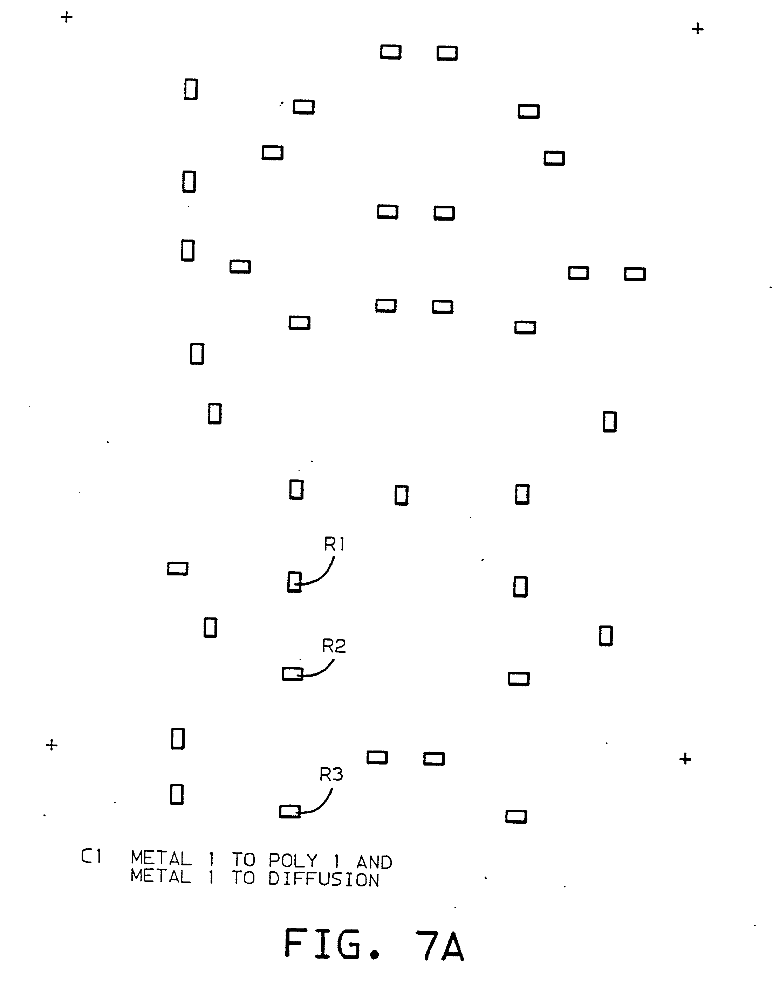

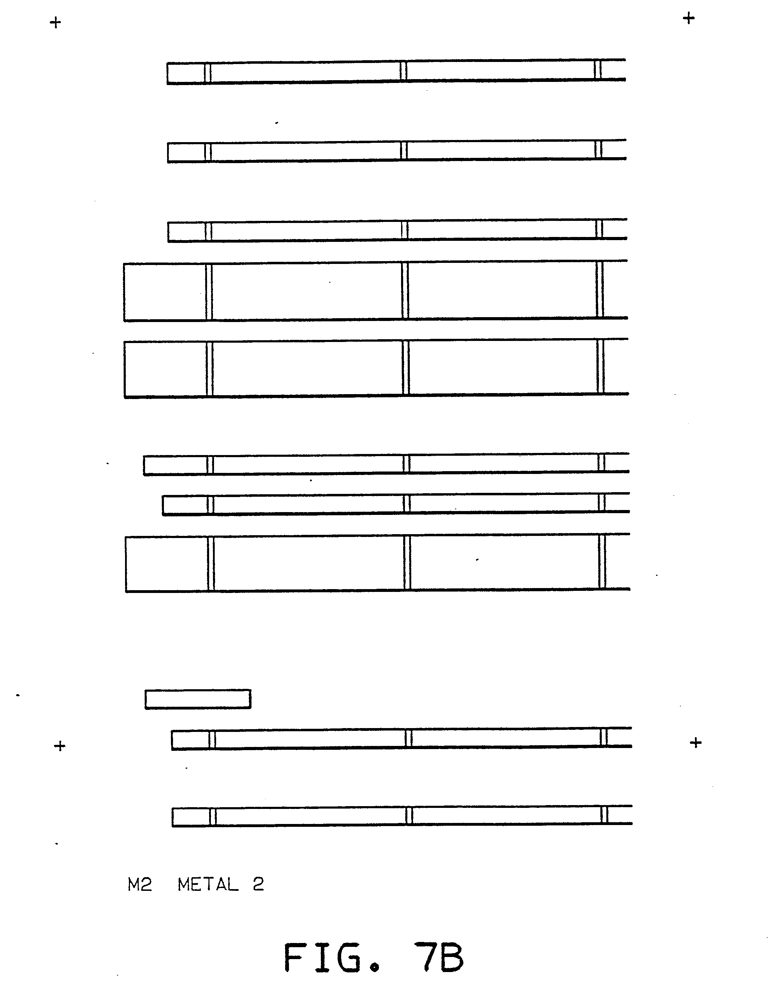

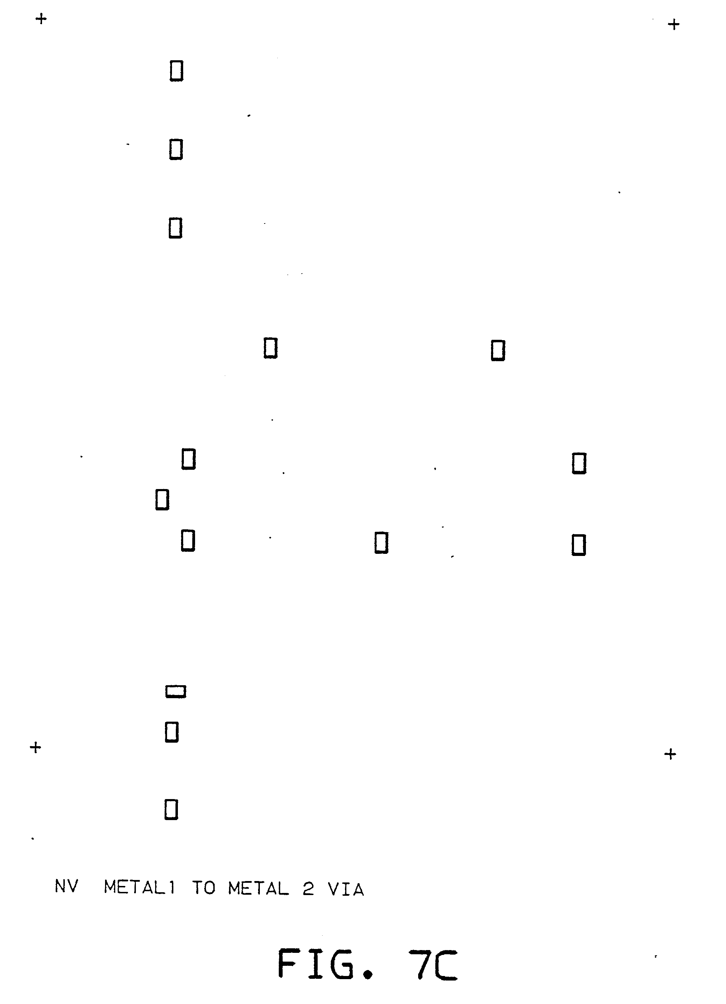

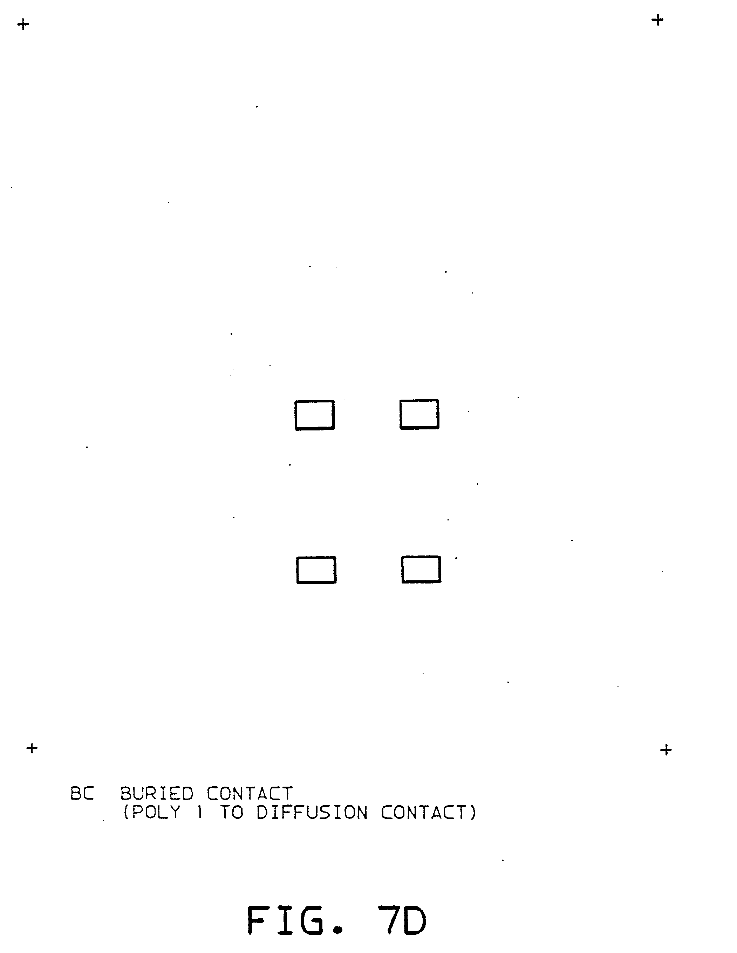

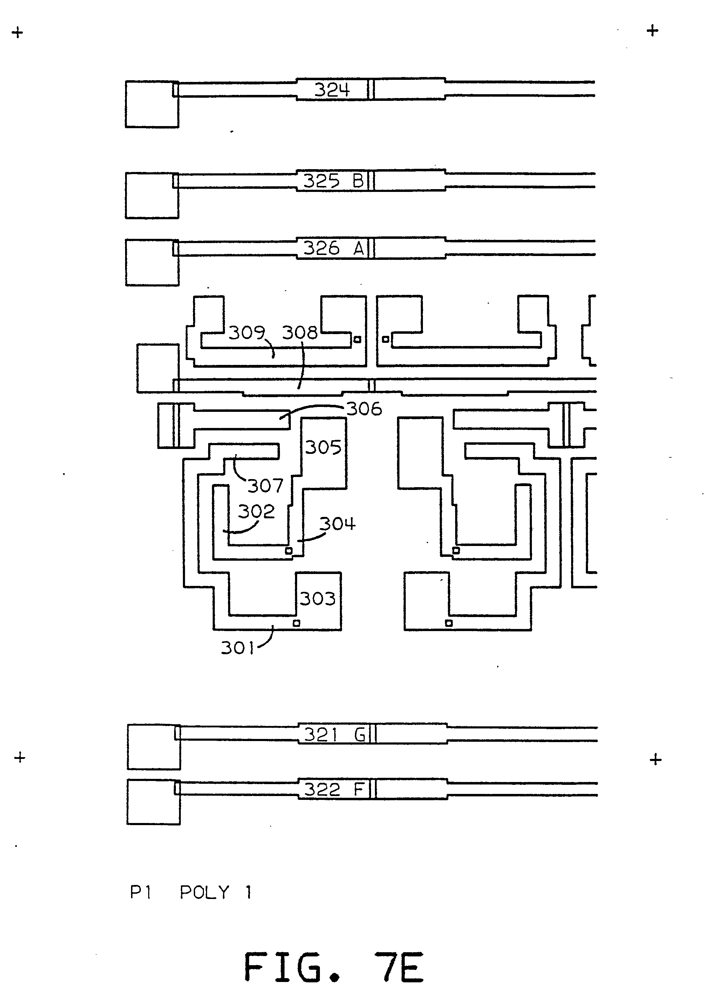

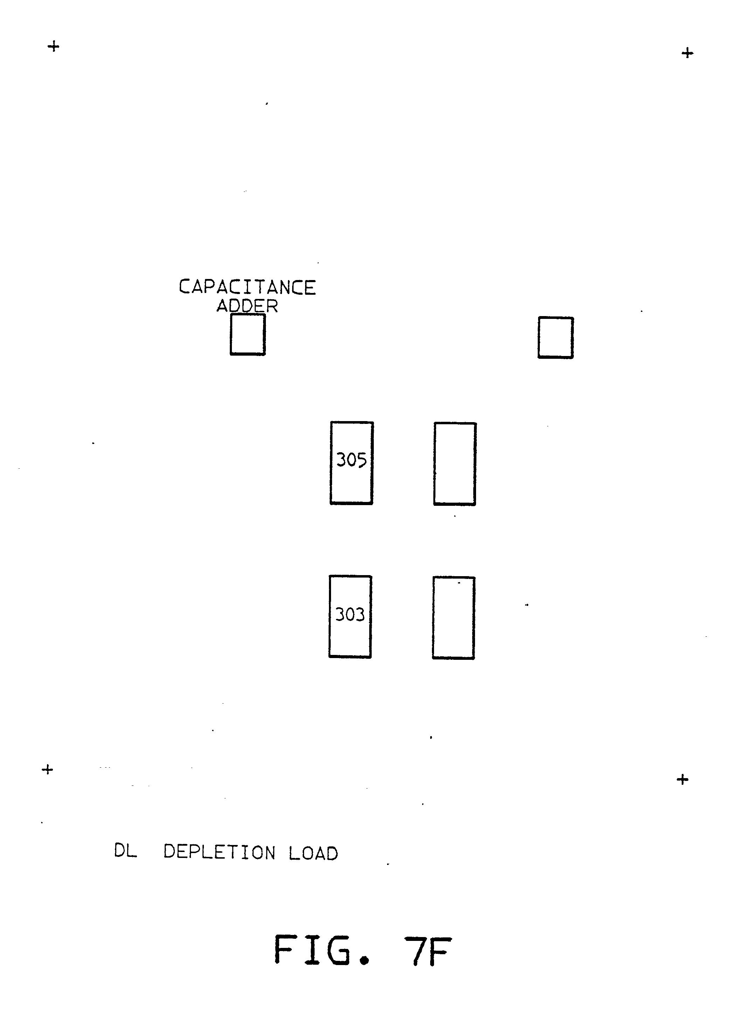

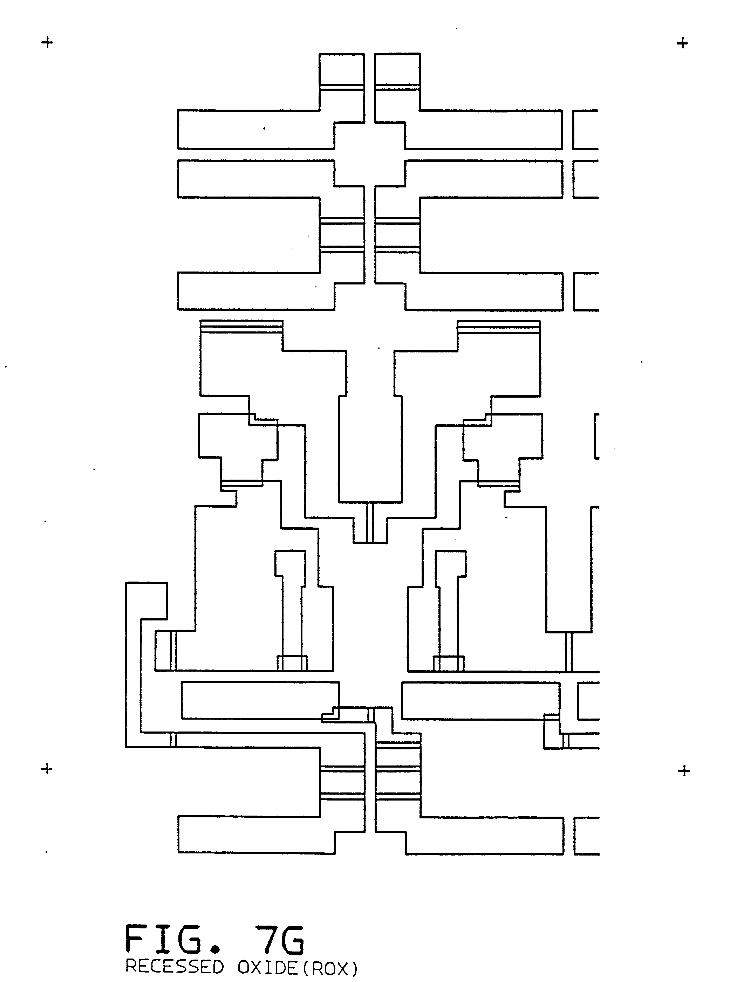

Prior to explaining the layered structure of the chip that is shown in Fig. 6 and 7a through 7h, reference should be made again to Fig. 1 for purposes of reviewing the arrangement of the buses in the individual conductors in the bus. As shown schematically in Fig. 1, the buses are divided into four groups, 1 through 4. Each group can have up to 7 buses which may be, but do not have to be, used for global wiring between functional blocks. The buses each contain one conductor per stage so that under the assumptions made earlier in connection with the preferred embodiment, each bus has 32 individual conductors. Each conductor of the 32 conductors in a bus is physically positioned and located relative to its associated stage in the same location, and logically and electrically related to the circuit of that stage in the same manner. The buses in each group are therefore identified by the position of their respective conductors relative to each stage. The buses shown in Fig. 1 are the buses employed for global wiring, i.e., interconnecting functional blocks. It should be understood that the metal 1 layer may also include other conductors that are employed to provide intrastage connections. These latter conductors will be discussed in more detail in connection with Figs. 6 and 7. In Fig. 1, group 2 of the buses, is at the right edge of stack LS and group 3 is at the left edge of stack CS. Bus group 4 is shown at the left edge of stack RS and bus group 1 has only two buses illustrated at the left side of stack LS to provide input to blocks L11 and L12.

The proper allocation of the number of buses (7 in this embodiment) is key to the ability to use members of a family of predesigned functional units. For example, all of the registers, multiplexers, RAM's, parity checkers and generators as well as the error checking functional units and Received Address Logic in this particular implementation were predesigned for another chip.

The bus allocation criteria taught by this invention is the following: The number of buses needed is a function of the maximum number, x, of functional blocks stacked in a single stack and the average number of service terminals, y, for any one bit processing unit within the "average" functional block. By assuming that these functional blocks are randomly ordered, an analogy can be made between bus allocation and channel allocation for random logic, a problem well described in the literature. For example, standard wirability theory predicts that 7 to 8 channels is sufficient to wire 25 stacked blocks having an average of 3 to 4 service terminals per block and that every additional two channels can support a doubling of the number of blocks within the stack.

Fig. 6 is the schematic view of the various structures on each layer of the chip shown in Fig. 1 with the layers superimposed on each other. Fig. 6 represents two stages of a register that employs the polarity hold latch described in connection with Figs. 4 and 5. Adjacent stages are mirror images of each other about the common vertical edges. The width "w" of the stage reflects the number of conductors, global and non-global, that were chosen and the wiring pitch for the various buses. The relative conductor location of 5 of the 7 global conductors associated with each bit are referenced as conductors 401-405 respectively in Fig. 6. The other two global conductors associated with each bit are not shown in Fig. 6, as they are not routed through the bit directly, but instead traverse the periphery of every 4 bit group. The height of the cell is reflected by the layout of the devices employed for the circuit, i.e., in this case the latch, and the number of multiplexed inputs for this particular latch. Fig. 6 shows the layout of the FET devices 301 to 309 and FET gates 321, 322, 325, and 326. These devices and gates are also shown in Fig. 7e, which illustrates a view of the poly layer containing the devices and gates. In addition to showing the general relationship of the various elements in each layer relative to each other, Fig. 6, along with the individual layers, shown in Figs. 7a - 7h are helpful in understanding how the various connections are made between metal layers and between each of the metal layers and the layers containing the devices.

For example, the vertical conductor 350 labeled "Q buffer n" in Fig. 6 and Fig. 7h is connected to three areas of the chip represented by small rectangles, R1, R2, and R3, shown also in Fig. 7a, corresponding to plated through holes on the chip. Rectangle R1 connects conductor 350 to devices 301 and 302; rectangle R2 connects the conductor 350 to device 321 of the next stage, while rectangle R3 connects conductor 350 to gate 322. Conductor 350 is from bus 3 and is disposed at about the middle of the stage.

The conductor on the far right of the left stage labeled 312 corresponds to the conductor in Fig. 4 that connects the output of gates 321-326 to terminal 312 and to the gate electrode of device 309. The output of this conductor 312 in Fig. 6 can be followed more easily with the help of Fig. 7h which shows only the metal 1 layer.

It should be readily understood from Fig. 1 and Fig. 6 that with the corresponding stages of the functional blocks stacked in a vertical alignment and with each stage having access to the same number of global conductors all of which are in a predetermined location relative to each stage, the problem of interconnecting functional blocks in a data flow path is substantially reduced and an opportunity to use more of the chip area is provided without a proportional increase in wiring complexity. It should also be evident that a large percentage of the FET devices have been allocated to the stacked blocks.

While the invention has been particularly shown and described with reference to the preferred embodiment thereof, it will be understood by those skilled in the art that various changes in the form and details may be made therein without departing from the spirit and scope of the invention.

Having thus described our invention what we claim is new and desire to secure by letters patent is.

## Claims

1. An integrated circuit chip (10) for large scale integration of a data processing application comprising a number of functional blocks (L12 to L36, C60 to C80 and R90 to R103) with an n-bit wide data flow path for transferring a data word having n-bit positions from an n-stage source functional block to an n-stage destination functional block on said chip through at least one other n-stage functional block in said data flow path; said chip being characterized in that :

said stages of each said block having the same physical width "w" with logically adjacent stages in each said block being also physically adjacent and extending in a direction parallel to the horizontal sides of said chip to cause each said block to have the same physical width $W = nw$,

each stage having a 1-bit processing circuit comprising a plurality of semiconductor devices which have been combined in a predetermined pattern in said chip and interconnected to perform a predetermined bit processing function, each said circuit having at least one input terminal (42), at least one output terminal (41) and at least one other type terminal (43),

said blocks being positioned on said chip in a vertical stacked array with corresponding stages of said blocks in said array in alignment in a direction parallel to the vertical sides of said chip,

said chip further including at least one conductive layer having a plurality of conductors (40) disposed parallel to said vertical sides with a density that provides at least T conductors for each stage where T is equal to or greater than the maximum number of said terminals in any one individual said stage in any said block in said array,

at least one more layer including a plurality of conductors (50) disposed in a direction parallel to said horizontal sides,

said input and output terminals of each said aligned stages being connected to conductors in said at least one conductive layer that are physically positioned in registry with the stage to establish said n-bit wide data flow path, and said other terminals of said stages of at least one said block being connected to selected said conductors in said at least one more layer that are in registry with said stages of said at least one block to provide control signals for controlling the operation of said data path.

2. The chip according to Claim 1 in which said functional blocks have a relatively high percentage of the total semiconductor devices embodied on said chip (10).

3. The chip according to Claim 1 or 2, in which said blocks are arranged in stacked arrays which are disposed parallel to each other on said chip (10).

4. The chip according to Claim 1, 2 or 3 in which said functional blocks include at least one said block which functions as as data storage register (L15, L16) and at least one said block that functions as a multiplexor (L22, L25 or L28).

5. The chip according to claim 4 in which said data storage register block (L15) has a latch circuit in each said stage.

6. The chip according to Claim 5 in which said latch circuit comprises a plurality of semiconductor devices (301-309) which are interconnected to form a polarity hold function.

7. The chip according to Claim 6 in which each said latch circuit is interconnected to an adjacent latch circuit to permit said circuits to be LSSD tested.

8. The chip according to Claim 7 in which said latch circuit includes an input terminal (312) and said stage further includes an input multiplexor for selectively switching one of a plurality of input signals (321-326) to said input terminal in response to different control signals supplied to said input multiplexor.

9. The chip according to claim 6, 7 or 8 in which said plurality of semiconductor devices are FET type transistors.

10. The chip according to Claim 9 in which some of said FET type transistor in selected stages of predetermined blocks are interconnected by said conductors (40) disposed on said at least one conductive layer.

II. The chip according to any one of claims 3 or 5 to 10 in which at least one of said stacked arrays extends from one side of said chip to the opposite side of said chip and includes at least 20 functional blocks.

I2. The chip according to any one of the preceding claims in which said plurality of conductors (40) in said at least one conductive layer are allocated to establish the plurality of "n" conductor buses and in which said plurality of buses are arranged in at least one group having at least 7 buses which may be employed for global wiring.

FIG. 1A

R90

RSC CNTL(LRXS)

R91

10

X25
X 9
X20

**FIG. 1B**

| FIG. 1A | FIG. 1B |
|---------|---------|
| FIG. 1C | FIG. 1D |
| FIG. 1E | FIG. 1F |

**FIG. 1G**

IBM-AT 984 067

0 182 041

L21 — CHK BIT GEN(LQFF) (LECO)

218

202

224 C70 PIO A(3:1) MUX(LQGP)

223

L22 — FORMAT MUX(LQFG)

C71 PIO ALT(4:1) MUX(LQGD)

L23 — SYN/RASREG(LQFE/FR)

C72 RM SR/TCR REG(LQGC)

222

L24 — SYD GEN/TIDR(LQFD&GS)

C73 TRAR REG(LQGG)

L25 — PIO MUX(LQGK)

C74 SEAR REG(LQGB)

L26 — ADRTG/LK/TIDIN REG(LQHN)

C75 DEAR1 REG(LQFA)

C76 DEAR2 REG(LQFB)

L27 — REPLY & CONC COMP(LQHW)

C77 STG REG(LQHY)

204

14

31

(204=201//203)

217

43

14

5

24

28

22

211

50

FIG. 1C

STORAGE INTERFACE
CNTL        (LQFN)

X 16  R92 DUAL TIMER(LQIC)

R93  TIMER REG(LQIB)

8  R94  ADR EX(LQGJ)

R95  RPNNREG(LQHO)

18    "FM"

201

# FIG. 1D

FIG. 1E

0 182 041

201 R96 SEG RAM(LQHB)

R97 RPN RAMO(LQHF)

R98 RPN RAM1(LQGK)

R99 FMTR(LQGC)

R100 RPNOMUZ(LQHZ)

R101 RPNPMUX(LQGM)

R102 LRULOG(LQHU)

R103 LRU REG(LQHU)

216

210

CP1

FIG. 1F

3M-AT 984 067

| FIG. 2A | FIG. 2B | FIG. 2C |
|---------|---------|---------|
| FIG. 2D | FIG. 2E | FIG. 2F |
| FIG. 2G | FIG. 2H | FIG. 2I |

# FIG. 2J

# FIG. 2A

FB  C76   FA  C75

DEAR 2

DEAR 1

222

C70

MUX GO

223

0 182 041

FIG. 2B

ARRAY DATA

CORRECTED ARRAY DATA

"VALID" FROM CONTROL

# FIG. 2C

TO RSC, CFE

R94

HN

L26

HO    R95

RSC ADDR EXT    GJ

L33    R97    L35

L34    R98    L36

| ADDR TAG | RPN | V | K | W | TID | LOCK | |
|----------|-----|---|---|---|-----|------|---|
| | | | | | | | 0 |
| | | | | | | | 1 |
| HD   HE | HF | | | | HG | HH | 2 |
| | | | | | | | 3 |
| | | | | | | | 14 |
| | | | | | | | 15 |

| ADDR TAG | RPN | V | K | W | TID | LOCK |
|----------|-----|---|---|---|-----|------|
| | | | | | | |
| | | | | | | |
| HI   HJ | HK | | | | HL | HM |
| | | | | | | |
| | | | | | | |
| | | | | | | |

205

206

FIG. 2D

FIG. 2E

0 182 041

FIG. 2F

L23

RAS MODE
DIAGNOSTIC

FR

TO CFE
"RANGE A"

TO ECC
LOGIC

FROM
ECC
LOGIC
"CHECK
BITS"

# FIG. 2G

(—AT 984 067

FIG. 2H

0 182 041

FIG. 2I

C80

SER

GN

215

EXCEPTION

ARRAY
CONTROL

FIG. 3A

# FIG. 3B

FIG. 4

DYNAMIC MASTER LATCH LOGIC EQUIVALENT

W/L1 •——— "AND" M  326

D1 •———

322

HOLD •——— "AND" 2

# •———

SEE NOTE  312 SIMULATED

DUMMY "OR"

L1 LATCH STORAGE ELEMENT

SHIFT •——— "AND" 1

* •———

321

STATIC SLAVE LATCH LOGIC EQUIVALENT

308,309  305 SIMULATED

READ WORD LINE •——— "AND"

"NOR"

301,302

314

"INV"  "INV"

Q BUFFER (n)

311

L2 CLOCK •——— "AND"

Q NOT n

303,304

306,307

Qn

313

# Q BUFFER(n)
* Q BUFFER(n-1)
NOTE:  ONE AND ONLY ONE OF AND GATES 1-M IS
       SELECTED EVERY CYCLE.  THIS IS ACCOMPLISHED
       WITH A SELECT 1 OF M CLOCKED DECODE
       NOT SHOWN IN THIS FIGURE.

# FIG. 5
DATA LATCH LOGIC EQUIVALENT

FIG. 6

M - AT 984 067

+                                +

R1

R2

+                                +

R3

C1   METAL 1 TO POLY 1 AND
METAL 1 TO DIFFUSION

# FIG. 7A

M2   METAL 2

# FIG. 7B

M-AT 984 067

NV  METAL1 TO METAL 2 VIA

# FIG. 7C

BC   BURIED CONTACT
     (POLY 1 TO DIFFUSION CONTACT)

# FIG. 7D

M-AT 984 067

P1   POLY 1

# FIG. 7E

CAPACITANCE
ADDER

305

303

DL   DEPLETION LOAD

# FIG. 7F

M-AT 984 067

# FIG. 7G
RECESSED OXIDE(ROX)

401 403 405
402 404

312

350

Q BUFFER n 312

M1 METAL 1 LEVEL

FIG. 7H